# EUROPEAN PATENT SPECIFICATION

(11) **EP 0 396 666 B1**
(45) Date of publication and mention of the grant of the patent: **20.03.1996**
(21) Application number: 89910510.0
(22) Date of filing: 30.08.1989
(51) Int. Cl.: G06F 17/10

(54) **SELECTIVE ACTIVE CANCELLATION SYSTEM FOR REPETITIVE PHENOMENA**
SELEKTIVES AKTIVES SYSTEM ZUR UNTERDRÜCKUNG VON SICH WIEDERHOLENDE ERSCHEINUNGEN
SYSTEME D'ANNULATION ACTIF SELECTIF POUR PHENOMENES REPETITIFS

(30) Priority: 30.08.1988 US 238188
(43) Date of publication of application: 14.11.1990
(73) Proprietor: NOISE CANCELLATION TECHNOLOGIES, INC., Columbia, MD 21046 (US)
(72) Inventor: ZIEGLER, Eldon, W., Jr., Columbia, MD 21046 (US)
(74) Representative: Brown, David Alan
(86) International application number: PCT/US89/03907
(87) International publication number: WO 90/02380

(56) References cited:
- WO-A-81/00638
- GB-A- 2 088 951
- US-A- 4 649 505

## Description

The present invention relates generally to a repetitive phenomena cancellation controller, and more specifically to a fast adapting, low-cost solution to this problem which is also capable of manual tuning.

Linear flow, air duct systems, for example, Chaplin U.S. Patent 4,122,303; Warnaka, U.S. Patent 4,473,906 and Eriksson U.S. Patents 4,677,676 and 4,677,677, take advantage of directional flow in linear, one dimensional flow to utilize an upstream sensor, followed by a cancellation actuator and downstream error sensor in sequence. These systems cancel repetitive and random noise. Chaplin characterizes the controller as a general convolution process, including a "programmed of time-related operational steps." Warnaka uses adaptive filters to speed adaptation time and allow greater spacing between the speaker and the duct. Eriksson specifies recursive least mean square (RLMS) and least mean square (LMS) adaptive filters to perform the convolutions and measure the system transfer functions in the presence of noise.

These systems fail to utilize external synchronization timing to provide selective cancellation of repetitive phenomena in one to three dimensional applications, and require both an upstream and a downstream sensor.

Systems for cancelling repetitive noise and vibration, for example, Chaplin U.S. Patents 4,153,815 and 4,417,098, describe the use of a synchronizing timing signal to provide selective cancellation of repetitive noise or vibration. Additionally a controller, actuator and error sensor are used. The method presented by Chaplin in these patents divides the noise or vibration period into a number of intervals and adjusts the amplitude of the cancelling signal within each interval in response to the sign or amplitude of the error sensor within the same or a delayed interval.

In U.S. Patent 4,490,841, Chaplin describes the use of Fourier transforms to process signals in the frequency domain. While this method might be used for random signals, processing time requirements generally limit its application to repetitive signals.

These systems use expensive or complicated filters and do not account for variable delays in the system. Also, they require both a synchronizing sensor and an error sensor and they adapt too slowly to be manually tuned.

Cancellation of unwanted components within electronic signals generally is applied to communication signals. Rennick et al. in U.S. Patent 4,232,381, use a commutating filter synchronized to the rotation of an engine to cancel self-generated engine noise within an electronic circuit. The level of the cancelling signal is adjusted manually and no method is provided to adapt to phase shifts or varying amplitudes of different harmonics.

Garconnat et at. in U.S. Patent 4,594,694 use two sensors, one sensing both the wanted and unwanted signals and the other sensing only the unwanted signals. Narrow band filters or Fourier transforms are used to eliminate the unwanted signals from the combined signal.

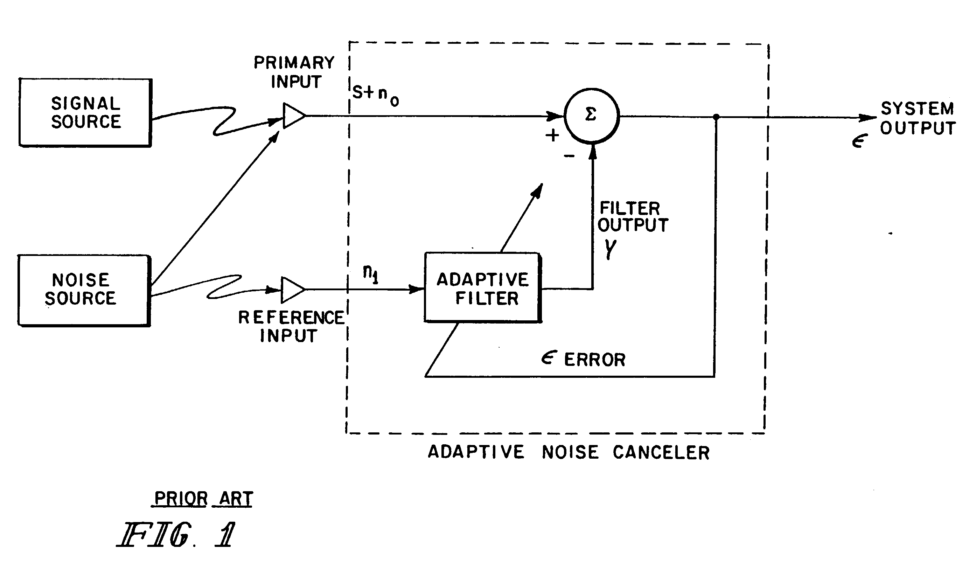

Widrow in "Adaptive Noise Cancelling Principles and Applications", Proceedings of the IEEE, VOl. 63, No. 12, December, 1975 describes two forms of active adaptive cancellers. The first, as illustrated in present Figure 1, uses a multi-tap adaptive FIR filter with a reference signal correlated with the noise to be cancelled. The reference signal is required to be within 90° in phase of the error signal. Consequently, the reference signal used by the adapter itself often requires filtering; the resulting approach is referred to as the "filtered-x algorithm."

The second form described by Widrow, as illustrated in present Figure 2, provides a single frequency notch filter and requires only two signal tap filters. Again, a reference signal correlated with the noise is used and is phase shifted90° for one of the filter. Glover, in "Adaptive Noise Cancelling of Sinusoidal Interferences," Stanford University, Stanford, California, May 1975, Ph.D. dissertation, extended this technique to multiple frequencies.

Each of Widrow's techniques requires two sensors, namely a sensor for the reference signal and a sensor for the error signal.

Thus it is a preferred aim of the present invention to provide an improved selective active cancellation system for repetitive phenomena which can adapt fast enough to be used with or without a sengor for reference or timing signals.

Another aim is to provide an active cancellation system using relatively inexpensive and uncomplicated filters in combination with external synchronized timing from a sensor or timing source.

Still, another aim of the present invention is to provide a selective active cancellation system for repetitive phenomena that may require only an error sensor in combination with a reference or timing signal.

Another aim is to provide a selective active cancellation system for repetitive phenomena that can be tuned manually or automatically without a sensor on or near the source of the repetitive phenomena to select the fundamental frequency, and therefore the harmonics of which, that are to be cancelled.

A further aim of the present invention is to provide an improved rate of adaptation to changes in the level or frequency of the repetitive phenomena.

An even further aim of the present invention is to provide a cancellation system for repetitive phenomena which can account for variations in processing time and environmentally produced delays.

A still even further aim of the present invention is to provide selective cancellation of unwanted signal components and automatic adaptation to the levels and phases of the signal components utilizing synchronization timing signals and a single residual sensor.

An even further aim of the present invention is to provide for adaptation of the system to maintain an appropriate phase relationship without the use of external reference signals.

These and other aims can be obtained according to the invention of Claim 1.

A controller according to the pre-characterizing portion of Claim 1 is known from WO-A-8100638.

The controller of the present invention has a processor which can receive phenomena input signals and timing input signals representing initially the phenomena and subsequently the residual phenomena to be cancelled and the repetition rate of the phenomena respectively, and which can include inexpensive and simple adaptive filters for generating a cancellation signal by adapting its filtering characteristics as a function of the sum of the signal. The processor can be fast enough to adapt to errors in phase between the repetitive components to be cancelled and a cancelling waveform generated based upon a manually or automatically tuned timing signal without a sensor on or near the source of the repetitive phenomena. The timing signal may be close, but not exactly equal to the rate at which the phenomena is being produced.

An adaptive filter may include for each frequency to be cancelled, be it a single frequency and its harmonics or a plurality of fundamental frequencies, a sine and cosine generator responsive to the timing signal and providing inputs to first and second adaptive filters whose outputs are summed to provide the cancellation signal. First and second adaptors can adapt the first and second filter weights of the first and second filters as a function of the sensed phenomena signal which represents the residual phenomena and a signal received from the phase circuit so that the first and second adapter operates within 90° phase of the phenomena signal.

The phase circuit may measure the delay between providing the cancellation signal and receipt of the phenomena signal, and adjust the phase as a function of the measured delay. The phase circuit can also take into account and adjust the phase as a function of the processing delay of the processor. The phase circuit may include a test signal generator for generating a test signal which is combined with the cancellation signal and provided into the area to be monitored. A third adaptive filter can be provided for receiving the test signal and providing a filtered signal. A difference is taken of the filtered signal with the phenomena residual signal. An adapter may adapt the third filter weights as a function of the difference signal and a delayed test signal. The third filter weights represent the delay time of the system and are used to provide the appropriate phase correction.

Preferred features of the present invention will now be described, by way of example, with reference to the accompanying drawings, in which:
Figure 1 is an adaptive noise cancellation concept of the prior art;
Figure 2 is a single frequency adaptive notch filter of the prior art;
Figure 3 shows a block diagram of a selective cancellation controller according to the principles of the present invention;
Figure 4 is a block diagram of a single fundamental frequency cancellation processor according to the principles of the present invention;
Figure 5 is a block diagram of a multi-fundamental frequency cancellation processor according to the principles of the present invention;
Figure 6 is a block diagram of a system impulse measurement processor according to the principles of the present invention; and
Figure 7 is a flow chart of signal processes according to the principles of the present invention.

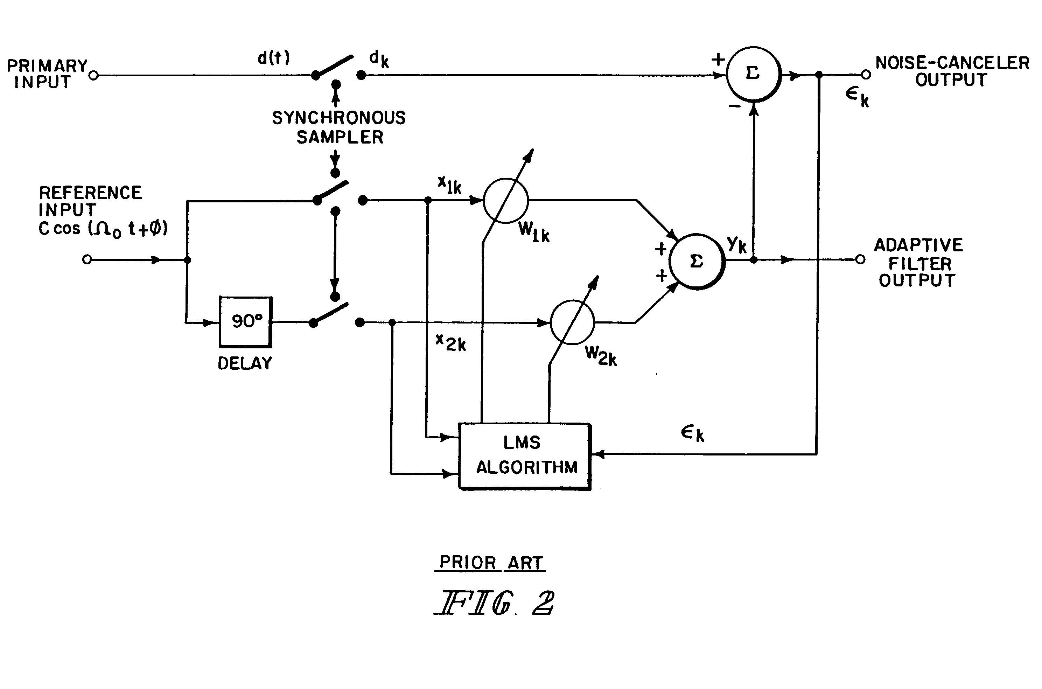

The repetitive phenomena cancellation controller 10 of the present invention illustrated in Figure 3 includes an input 12 for receiving a source of timing signals from 14 and input 16 for receiving the signals from the residual or phenomena sensor 18 and an output 20 of a cancellation signal to drive an actuator 22 to provide a cancelling phenomena into the area to be controlled.

The rate or timing signal sensor at input 12 is used to determine the fundamental frequency at which the repetitive phenomena is being generated. Multiple timing signals are used when the repetitive phenomena arises from sources occurring at different rates. This signal, or signals, may be, for example, derived from an engine tachometer, an optical sensor on moving equipment, a "clock" signal from electronically controlled or generated noise sources or by determining the rate from the repetitive phenomena itself, such as by use of a phased-locked-loop to track its timing. Alternately, when the rate is stable, an independent timing device, such as a precision function generator, can provide the timing signal.

The actuator 22 produces the cancelling repetitive phenomena from an electronic waveform to interact with the original repetitive phenomena such that the two sum algebraically. The actuator 22 can be, for example, a loudspeaker, headphone or other acoustic actuator; an electro-mechanical, electro-hydraulic, piezoelectric or other vibration actuator; or an electronic mixing circuit.

The sensor 18 detects the result of algebraically summing the original repetitive phenomena and the cancelling repetitive phenomena and converts this into an electronic waveform representing this residual. The residual sensor 18 might be, for example, a microphone, accelerometer, pressure sensor or the output of an electronic mixing circuit.

The controller 10 utilizes the timing signal(s) and residual sensor waveform to produce the cancelling waveform.

A timing input or electronic circuitry 26 converts the timing signal(s) for use in a processor 24. Such circuitry typically includes amplifiers, pulse shaping functions and possibly an adjustable rate frequency mulitplier/divider, such as a phased-lock-loop and counter, to increase/decrease the rate of the timing signal as required by the processor, for example to multiply a once-per-revolution tachometer signal by the number of points to be processed per revolution. The output is a process rate clock signal.

Phenomena input electronic circuitry 28, 30 converts the residual sensor signal for use in a processor 24, such circuitry typically consists of amplifiers 28, possibly with controllable gain, anti-aliasing filters 30, a sample-and-hold function and an analog-to-digital converter.

Output electronic circuitry converts output signals from the processor 24 into the cancelling waveform. Such circuitry typically consists of a digital-to-analog converter, a reconstruction filter 34 to remove the sampling frequency and an amplifier 36, as required.

The processor 24 provides the following:
1. A means for synchronizing processing to the timing signal(s);
2. A means for determining and updating the system impulse response;
3. Cosine and sine values at intervals determined by the number of points to be processed per cycle;
4. Means for convolving the cosine and sine values within the system impulse response to maintain the adaption of the filters weights within a 90° phase of the phenomena or residual signal;.
5. Storage for the filter weights;
6. Means for adapting the filter weights utilizing the residual signal value and the convolved cosine and sine values to minimize a function of the residual signal, such as an LMS algorithm; and
7. A means for producing the cancelling signal from the filter weights and the cosine and sine values.

The timing signal(s) synchronize processing with the rate(s) at which the repetitive phenomena is being produced. These rates determine the length of the repetition cycle, depending on the source of the phenomena. For example, a repetition cycle occurs every revolution of an electric motor and every other revolution of a four cycle engine. This rate also determines the fundamental frequency of the repetitive phenomena. For example, an electric motor running at 1800 RPM completes 30 revolutions per second with a fundamental frequency of thirty Hertz. A four cycle diesel engine running at 1800 RPM also completes thirty revolutions per second, but with only fifteen complete firing cycles per second and a fundamental frequency of fifteen Hertz.

The timing signal(s) are frequency mulitplied and/or divided, if necessary, to produce the process rate clock(s) providing Sn points within each repetition cycle. Often Sn is a power of two, such as 128, to facilitate computation.

The processor 24 can be synchronized with the process rate clocks via interrupts, digital interfacing or other methods of interfacing the process rate clocks with the processor.

The sample rate clock on input 32 can be set to a fixed rate or taken directly from the process rate clock. Some degradation of cancellation can occur if a fixed rate is used but a simpler system can result since fixed frequency filters can be used.

The processor 24 can be implemented in various forms including fixed program hardware, custom chips or in one or more stored program microprocessors. The functions of the processor 24 are to compute and update filter weights that result in minimizing the mean square value of the error signal and, when needed, to determine the sampling rate and system impulse response.

The cancellation signal processing calculations are performed at each sample interval and, therefore, are critical to processing speed. Processing speed in turn determines the number of harmonics that can be cancelled at a given sample rate while maintaining rapid adaptation. Of course, the processing speed must be fast enough to cancel the minimum number of harmonics are an application.

Several factors interact to influence the effect of processing speed. In order to be selective the sample rate depends on the rate at wh-ich noise is being generated and on the number of sample points per noise cycle. For example, an electric motor running at 1200 RPM completes one cycle 20 times per second. Sampling 128 points during the cycle gives a sample rate of 2,560 samples per second or one sample every 390 microseconds. Thus, the cancellation signal calculations must be able to be performed completely in less then 390 mircoseconds in such an application.

The processor can be configured to cancel a single fundamental frequency plus harmonics or to cancel multiple frequencies, each possible with harmonics.

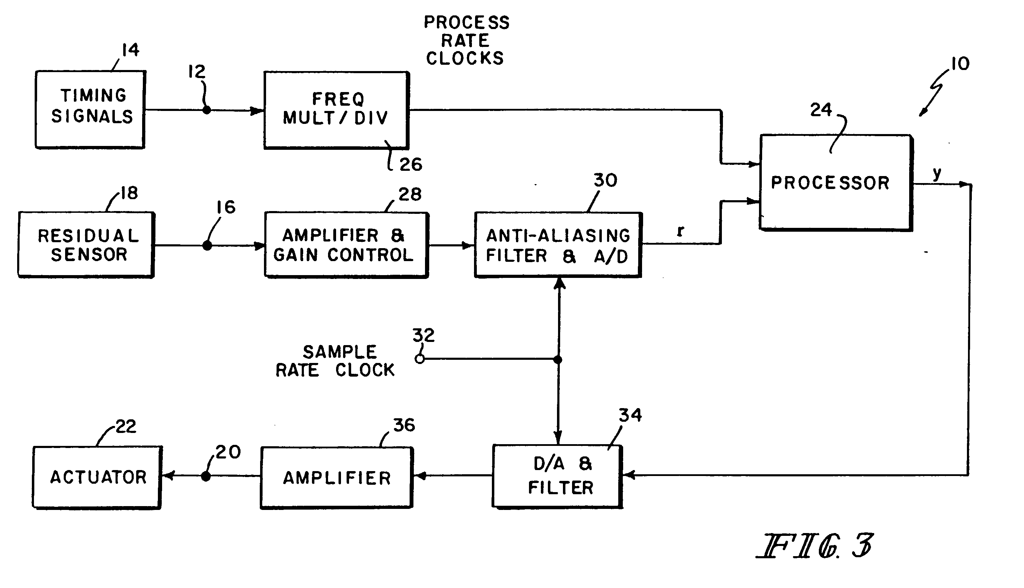

Referring to Figure 4, the cancellation signal y_{c} at sample k for a single fundamental frequency processor is computed as:${\text{y}}_{\text{c}} {\text{[k] = - Σ}}_{\text{h}} {\text{(w}}_{\text{0,h}} {\text{[k] ∗ x}}_{\text{0,h}} {\text{[k] + w}}_{\text{1,h}} {\text{[k] ∗ x}}_{\text{1,h}} \text{[k]),}$ where w_{0,h}[k] and w_{1,h}[k] are the values of the filter weights for harmonic h at sample k; and${\text{x}}_{\text{0,h}} \text{[k] = cos (h ∗ 2 ∗ pi ∗ k/Sn)}$${\text{x}}_{\text{1,h}} \text{[k] = sin (h ∗ 2 ∗ pi ∗ k/Sn)}$ where Sn is the number of points processed per repetition cycle; h is the harmonic index, 1 for the fundamental, 2 for the first harmonic, etc.,; and, k sequences between 0 and Sn-1, changing at each processing sample interval.

A cosine and sine generator 40, 42 provides values at the fundamental frequency and harmonics of the process rate clock. The output of the sine and cosine generator x_{0,h} and x_{1,h} are provided to respective filters 44, 46 having weighting functions w_{0,h} and w_{1,h}. The output of the filters 44 and 46 are summed in the summer 48 to provide the output cancellation signal y_{c}. Filter weighting adaptors 50, 52 receive the residual signal r and modify it with the delayed signal from the sine and cosine generator through delay circuits 54, 56 respectively.

The adapters 50, 52 can be of any type that minimize the residual r, such as a LMS algorithm. When an LMS algorithm is used the filter weights are updated as:${\text{w}}_{\text{0,h}} {\text{[k] = w}}_{\text{0,h}} {\text{[k-1] + alpha ∗ r ∗ x}}_{\text{0,h}} {\text{[k-Delay}}_{\text{h}} \text{]}$${\text{w}}_{\text{1,h}} {\text{[k] = w}}_{\text{1,h}} {\text{[k-1] + alpha ∗ r ∗ x}}_{\text{1,h}} {\text{[k - Delay}}_{\text{h}} \text{]}$ where Delayₕ is the effect of the system impulse response at harmonic h and alpha is set to assure convergence. of the

The delay circuits 54, 56 reproduce the effects of the system impulse response from the cancellation signal y_{c} to the residual signal r. This impulse response includes the effects of the filters within the controller itself, which can dominate external factors. The purpose of the delay is to keep the x₀ and x₁ values going to the adapters 50, 52 within 90° phase of the residual signal r. Often, it is adequate to approximate the impulse response with a simple time delay. When that is not adequate, the delay circuits 54, 56 become convolutions of the signals x₀ and x₁ with the system impulse response.

Note that the values of the delay can depend upon the frequency, and thus, the harmonic.

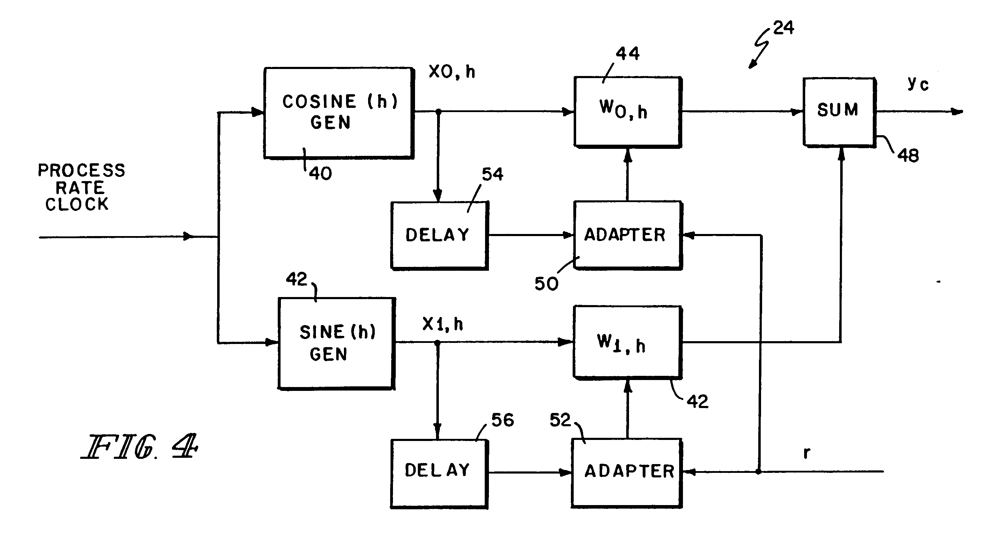

Referring to Figure 5, multiple processing rate signals can be utilized, one for each fundamental frequency. A plurality of process rate clocks PRC are shown being fed to their individual single fundamental frequency processors SFFP 24. Their outputs are combined in a summer 58. The single fundamental frequency processors 24 would each include the configuration of Figure 4 having a pair of adaptable notch filters 44, 46, as well as the other circuitry illustrated therein.

The cancellation signal y_{c} at sample k is computed as:${\text{y}}_{\text{c}} {\text{[k] = - Σ}}_{\text{f}} {\text{(w}}_{\text{0,f}} {\text{[k] ∗ x}}_{\text{0,f}} {\text{[k] + w}}_{\text{1,f}} {\text{[k] ∗ x}}_{\text{x,f}} \text{[k])}$${\text{x}}_{\text{0,f}} {\text{[k] = cos (2 ∗ pi ∗ f ∗ k}}_{\text{f}} \text{/Sn)}$${\text{x}}_{\text{1,f}} {\text{[k] = sin (2 ∗ pi ∗ f ∗ k}}_{\text{f}} \text{/Sn)}$ where Sn is the number of points processed per repetition cycle; and, k_{f} sequences between 0 and Sn-1 independently for each fundamental frequency f, changing at each processing sample interval.

As before, the adapters can be of any type that minimize the residual r, such as a LMS algorithm. Whan an LMS algorithm is used, the filter weights are updated as:${\text{w}}_{\text{0,f}} {\text{[k] = w}}_{\text{0,f}} {\text{[k-1] + alpha ∗ r ∗ x}}_{\text{0,f}} {\text{[k - Delay}}_{\text{f}} \text{]}$${\text{w}}_{\text{1,f}} {\text{[k] = w}}_{\text{1,f}} {\text{[k-1] + alpha ∗ r ∗ x}}_{\text{1,f}} {\text{[k - Delay}}_{\text{f}} \text{]}$ wherein Delay_{f} is the effect of the system impulse response at frequency f; and, alpha is set to assure convergence.

Note that the values of delay depend on the frequency.

Multiple harmonics of each fundamental frequency can be cancelled as described earlier.

The purpose of measuring the system impulse response is to adjust the cosine and sine values to be within 90° phase of the residual signal. In the general case the phase correction is accomplished by convolving the cosine/sine values with the system impulse response. Often, it is sufficient simply to delay the cosine/sine values by the delay introduced between the processor output and the residual value input. The delay can be caused by the anti-aliasing filters, reconstruction filters and delays in the environment, such as the distance between the actuator and residual sensor.

When the system time delay is fixed and know in advance, the values can be built into the processor and real-time measurement omitted.

In other applications, the system impulse response must be measured and system delay calculated therefore. These two processes are performed when needed to self-calibrate the system. In practice, the system response tends to change slowly. For example, self-calibration in an automotive application might take place each time the vehicle is started. Consequently, this element does not affect the speed of adaptation. In applications for which ongoing measurement of the system response is required this element can be implemented as a concurrent process with cancellation signal processing.

When needed, several methods of measuring the system impulse response are available. These include a swept sine (single frequency) signal, an impulse generator, a pseudo random test signal correlated with the response and a pseudo random test signal plus an adaptive filter.

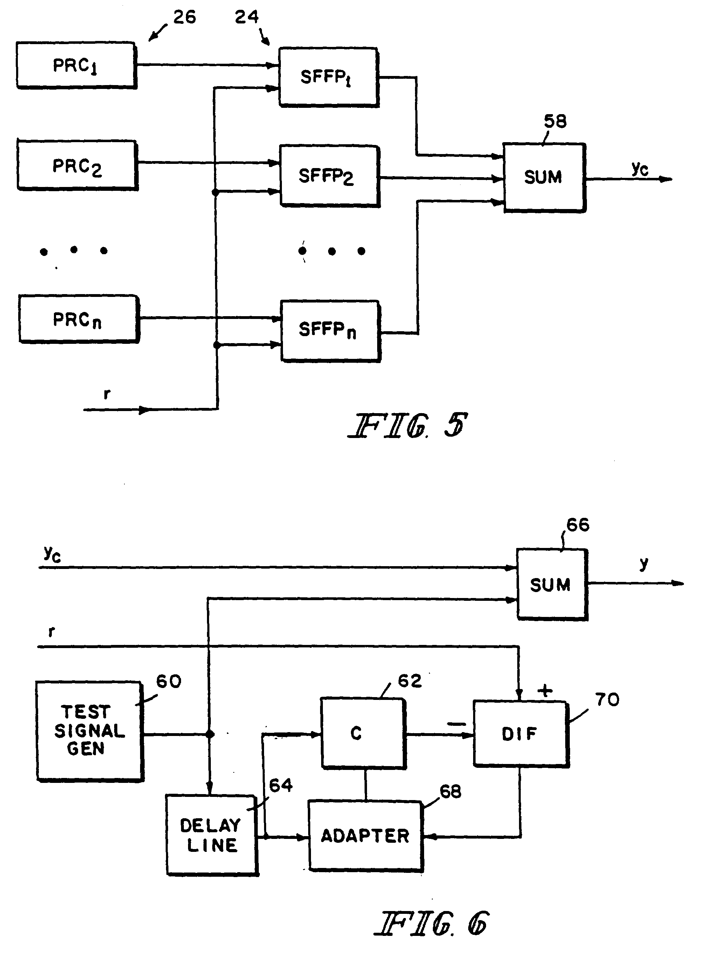

The preferred approach of measuring the system impulse response as illustrated in Figure 6, utilizes a pseudo random test signal generator to generate a pseudo - random noise 60 plus an adaptive filter 62 which is adapted to match the system's impulse response. The pseudo random test signal is stored in a delay line 64 and added to the cancellation output, y_{c} at adder 66. The weights of the adaptive filter are adjusted by adapter 68 using a minimization algorithm, such as a LMS algorithm, by using the difference from differencer 70 between the residual sensor value r and the convolution of the contents of the delay line and the filter weights. When the LMS algorithm is used, the weights are updated by:${\text{C}}_{\text{j}} {\text{[k+1] = C}}_{\text{j}} \text{[k] + alphaC ∗ err ∗ yt[k-j]}$${\text{err = r - Σ}}_{\text{j}} {\text{(C}}_{\text{j}} \text{[k] ∗ yt[k-j])}$ where C[k] is the jth weight of the filter at sample k; yt[k-j] is the delay of pseudo random test signal values at sample k and jth weight; r is the residual senses signal value at the current sample; and, alphaC is set for convergence.

The resulting filter weights Cⱼ[k+1] approximate the system impulse response and are used by the processor 24 to set the delays 54, 56.

The preferred method of generating the pseudo random test signal is the use of a maximal length sequence generator. This sequency of the test signal yt[k] at sample k can be generated by:$\text{d[k] = d[k-28] xor d[k-31]}$ where d[k] is the binary value of the sequence at sample k.

The test signal yt[k] is generated by:
+ test signal level, d[k] = 1,
- test signal level, d[k] = 0. The test signal level typically is 25% to 50% of full scale. The number of filter weights and the sample rate are set to assure that the longest system time delay will be measured and that sufficient resolution is present to identify the shortest system time delay. For example, sixty four filter weights and a sample rate of 2 kHz suffice for many acoustic applications; providing a 0.5 millisecond resolution and up to 32 milliseconds delay, about sixteen feet in each direction.

Once the system impulse response has been measured, the system delay table is computed. The delay table contains the data needed during cancellation to adjust the adaptive algorithm for delays in the system response. The storage of these data in a table avoids time consuming computations during cancellation signal processing.

The data stored in this table are the cosine and sine of the phase shift at each frequency increment, e.g., each one Hertz from zero Hertz to the upper frequency limit to be cancelled. These are calculated from the system impulse response as:${\text{cosine value [f] = Σ}}_{\text{j}} \text{{Cj ∗ cos (2 ∗ pi ∗ j ∗ f/ Srcal)}}$${\text{sine value [f] = -Σ}}_{\text{j}} {\text{∗ {C}}_{\text{j}} \text{∗ sin (2 ∗ pi ∗ j ∗ f/ Srcal)}}$ where Srcal is the sample rate during calibration.

When the system impulse response can be approximated by linear phase, a single value of the system time delay describes its response. Then the values of Delayₕ and Delay_{f} can be provided by this single value. This value is adjusted to account for variations in the processing rate by:$\text{Delay = td ∗ Pr}$ where Delay is in processing interval units; td is the system time delay in seconds; and, Pr is the processing rate per second.

In the general case, the values of delay depend on the frequency. These delays can be determined by converting the impulse response into the frequency domain (e.g., by use of a Fourier or Hartley transform), and by calculating the delays from the phase values. An example of the calculation is:${\text{td}}_{\text{f}} \text{=} \frac{{\text{-phase}}_{\text{f}}}{\text{2 ∗ pi ∗ f}}$ where td_{f} is the time delay at frequency f, in seconds; phase_{f} is the phase at frequency f, in radians; and f is the frequency, in Hertz.

The values of Delayₕ or Delay_{f} in Figure 4 are then determined by:${\text{Delay}}_{\text{fh}} {\text{= td}}_{\text{f}} \text{∗ Pr}$ where fh = Fₒ * h with fₒ is the channel fundamental frequency and h is the harmonic index, or${\text{Delay}}_{\text{f}} {\text{= td}}_{\text{f}} \text{∗ Pr}$ Alternatively, the delay values of the sine and cosine values can be determined as:${\text{sin (theta + phase}}_{\text{f}} {\text{) = sin (theta) cos (phase}}_{\text{f}} {\text{) + cos (theta) sin (phase}}_{\text{f}} \text{)}$${\text{cos (theta + phase}}_{\text{f}} {\text{) = cos (theta) cos (phase}}_{\text{f}} {\text{) - sin (theta) sin (phase}}_{\text{f}} \text{)}$ where theta = 2 ∗ pi ∗ h ∗ t/Sn and${\text{f = f}}_{\text{o}} \text{∗ h}$

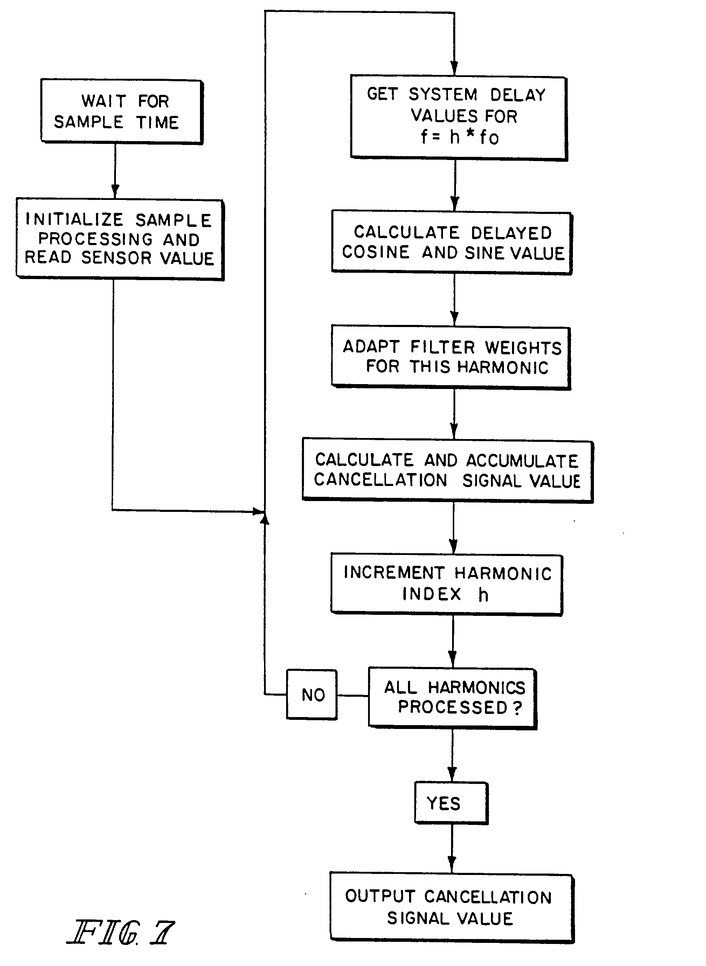

In a software implementation of a single sensor system, the system delay sine and cosine's and the sine and cosine of signed phase are stored in look-up tables and the processor 24 would perform the program outlined in Figure 7.

Initially, the process waits for a sample interval to begin in order to synchronize processing with sample timing. This determination can be via polling or be interrupt driven from sample timing.

Next, the sample processing is initialized and error sensor value is read. In this step the following are accomplished:
1. A/D conversion is started,
2. a sample counter "k" is incremented,
3. the lowest and highest harmonics to be processed are computed from the lowest and highest frequencies to be cancelled and the current sample rate as${\text{f}}_{\text{0}} \text{= Sr/Sn}$${\text{H}}_{\text{low}} {\text{= F}}_{\text{low}} {\text{/f}}_{\text{0}}$${\text{H}}_{\text{high}} {\text{+ F}}_{\text{high}} {\text{/f}}_{\text{0}}$ where:
   Sr is the current sample rate,
   Sn is the number of sample points per noise cycle,
   F_{low} is the lowest frequency to be cancelled and F_{high} is the highest frequency to be cancelled.
4. the accumulator to hold the cancellation signal value is set to zero,
5. the harmonic index "h" is set to H_{low} and,
6. the error sensor value is read.

In the get system delay values for current harmonic step, the cosine and sine values are retrieved from the System Delay Table where the index into the table is calculated as:${\text{f = h ∗ f}}_{\text{0}}$ where h is the index of the harmonic being processed and f₀ is fundamental frequency calculated as Sr/Sn.

In the calculate delayed cosine and sine values step, the cosine and sine values are retrieved from the Cosine and Sine Table. The delayed values of the cosine and sine are calculated as:${\text{DelayedCosine = CosineTable}}_{\text{kh}} {\text{∗ SysDelaycosine}}_{\text{f}} {\text{- SineTable}}_{\text{kh}} {\text{∗ SysDelaySine}}_{\text{f}}$${\text{DelayedSine = SineTable}}_{\text{kh}} {\text{∗ SysDelayCosine}}_{\text{f}} {\text{+ CosineTable}}_{\text{kh}} {\text{∗ SysDelaySine}}_{\text{f}}$ where k is the sample number,$\text{kh is k ∗ h}$
CosineTableₖ is the cosine value from the k'th entry in the Cosine and Sine Table,
SineTableₖ is the sine value from the k'th entry in the Cosine and Sine Table,
f is the frequency of the harmonic being processed,
SysDelayCosine_{f} is the cosine value from the f'th entry in the System Delay Table and
SysDelaySine_{f} is the sine value from the f'th entry in the System Delay Table.

In the adapt filter weights for the harmonic step, the filter weights are adapted via an LMS algorithm as:${\text{Wcos}}_{\text{h}} {\text{+ Wcos}}_{\text{h}} \text{+ alpha ∗ Err ∗ DelayedCosine}$${\text{Wsin}}_{\text{h}} {\text{= Wsin}}_{\text{h}} \text{+ alpha ∗ Err ∗ DelayedSine}$ where Err is the value read from the error sensor,

Wcosₕ and Wsinₕ are the filter weights for harmonic h and alpha is set convergence and fast adaptation. In the calculate and accumulate cancellation signal value step, the contribution of the current harmonic to the signal value is calculated and accumulated as:${\text{y}}_{\text{c}} {\text{= y}}_{\text{c}} {\text{+ Wcos}}_{\text{h}} {\text{∗ CosineTable}}_{\text{kh}} {\text{+ Wsin}}_{\text{h}} {\text{∗ SineTable}}_{\text{kh}}$

Next, the harmonic index h is incremented and a determination is made whether all the harmonics have been processed by comparing the value h to H_{high}. If the answer is no, the process is repeated beginning with getting system delay values for the next harmonic. If the answer is yes, the cancellation value is outputted.

The accumulated value of y_{c} is negated and converted as needed for the D/A hardware and output.

After this the process returns to the step, "Wait for Sample Time."

It will be understood that the present invention has been described above purely by way of example, and modifications of detail can be made within the scope of the invention.

## Claims

1. Repetitive phenomena cancellation controller comprising:
phenomena input means (18, 28, 30) for providing a phenomena signal representing a residual phenomena to be cancelled;
timing input means (14, 26) for providing a timing signal representative of a repetition rate of said phenomena;
processor means (24), having inputs for said phenomena signal and said timing signal, for generating a cancellation signal to substantially eliminate said phenomena;
output means (22, 34, 36) connected to said processor means for providing a cancellation phenomena as a function of said cancellation signal; and
adaptive filter means, in said processor means, for generating said cancellation signal by adapting the filter means filtering characteristics as a function of said phenomena signal and timing signal;
characterised in that:
said adaptive filter means includes, for each frequency to be cancelled:
sine and cosine means (40, 42) for generating a sine and cosine of said timing signal respectively;
first and second filter means (44, 46) for respectively receiving said sine and cosine signals and providing first and second cancellation signals as a function of first and second filter weights of said first and second filter means respectively;
summing means (48) for providing said cancellation signal as a sum of said first and second cancellation signals; and
first and second adapter means (50, 52) for adapting said first and second filter weights respectively as a function of said sine and cosine signals respectively and said phenomena signal;
further characterised by:
phase means (54, 56), in said processor means, for adjusting the phase of said sine and cosine signals provided to said first and second adapter means so that said first and second adapter means are within a 90° phase of said phenomena signal, whereby said adapting of said filtering characteristic is maintained within a 90° phase of said phenomena signal.

2. A repetitive phenomena cancellation controller according to Claim 1, wherein said phase means includes means for measuring a delay between providing said cancellation signal and receipt of said phenomena signal, and adjustment means for adjusting said phase as a function of a measured delay.

3. A repetitive phenomcna cancellation controller according to Claim 2, wherein said phase means includes means for measuring processing delays of said processing means and said adjusting means is adapted also to adjust said phase as a function of processing delay of said processor means.

4. A repetitive phenomena cancellation controller according to Claim 1, wherein said phase means includes:
test signal means (60) for generating a test signal, said test signal being provided to said output means;
third filter means (62) for receiving said test signal and providing a filtered signal as a function of third filter weights;
difference means (70) for providing a difference signal of said filtered signal and said phenomena signal;
delay means (64) for providing a delayed test signal from said test signal; and
third adapter means (68) for adapting said third filter weights as a function of said delayed test signal and said difference signal.

5. A repetitive phenomena cancellation controller according to any preceding claim, wherein said phase means includes means for setting a predetermined phase value.

6. A repetitive phenomena cancellation controller according to any preceding claim wherein said timing input means includes timing means for sensing said repetition rate of said phenomena and generating said timing signals.

7. A repetitive phenomena cancellation controller according to Claim 6 wherein said timing means includes a tachometer.

8. A repetitive phenomena cancellation controller according to Claim 6 wherein said timing means includes a phased-locked loop circuit.

9. A repetitive phenomena cancellation controller according to Claim 6 wherein said timing input means includes a function generator for generating said timing signals.

## Patentansprüche

1. Steuereinrichtung zur Löschung sich wiederholender Erscheinungen mit:
einer Erscheinungs-Eingangs-Einrichtung (18,28,30), um ein Erscheinungssignal zu liefern, das zu löschende Resterscheinungen darstellt;
einer Zeitablauf-Eingangs-Einrichtung (14,26), um ein Zeitablaufsignal zu liefern, das eine Wiederholungsrate der Erscheinungen darstellt;
einer Verarbeitungseinrichtung (24) mit Eingänge für das Erscheinungssignal und das Zeitablaufsignal, um ein Löschsignal zu erzeugen, um die Erscheinungen im wesentlichen zu beseitigen;
einer Ausgangseinrichtung (22,34,36), die mit der Verarbeitungseinrichtung verbunden ist, um Löscherscheinungen als Funktion des Löschsignals zu liefern; und
einer adaptiven Filtereinrichtung in der Verarbeitungseinrichtung, um das Löschsignal zu erzeugen, in dem die Filtereinrichtung angepaßt wird, die Charakteristiken als eine Funktion des Erscheinungssignals und des Zeitablaufsignals herausfiltert;
dadurch gekennzeichnet, daß
die adaptive Filtereinrichtung für jede zu löschende Filtereinrichtung folgendes beinhaltet:
eine Sinus- bzw. Kosinuseinrichtung (40,42) zur Erzeugung eines Sinusses bzw. eines Kosinusses des Zeitablaufsignals;
eine erste bzw. zweite Filtereinrichtung (44,46), um das Sinus- bzw. Kosinussignal zu empfangen und um erste bzw. zweite Löschsignale als eine Funktion erster bzw. zweiter Filtergewichte der ersten bzw. zweiten Filtereinrichtung zu liefern;
eine Summiereinrichtung (48), um das Löschsignal als eine Summe eines ersten und zweiten Löschsignals bereitzustellen; und
eine erste und zweite Adaptereinrichtung (50,52), um die ersten bzw. zweiten Filtergewichte als eine Funktion des Sinus- bzw. Kosinussignals und des Erscheinungssignals anzupassen;
weiter gekennzeichnet durch:
eine Phaseneinrichtung (54,56) in der Verarbeitungseinrichtung, um die Phase des Sinus- und Kosinussignals, das zu der ersten und zweiten Adaptereinrichtung geliefert wird, einzustellen, so daß die erste und zweite Adaptereinrichtung innerhalb einer 90°-Phase des Erscheinungssignals liegen, wodurch die Anpassung der Filter-Charakteristiken innerhalb einer 90° -Phase des Erscheinungssignals gehalten wird.

2. Steuereinrichtung zur Löschung sich wiederholender Erscheinungen nach Anspruch 1, bei welcher die Phaseneinrichtung eine Einrichtung zur Messung einer Verzögerung zwischen der Bereitstellung des Löschsignals und dem Empfang des Erscheinungssignals und eine Einstelleinrichtung zum Einstellen der Phase als eine Funktion einer gemessenen Verzögerung beinhaltet.

3. Steuereinrichtung zur Löschung sich wiederholender Erscheinungen nach Anspruch 2, bei welcher die Phaseneinrichtung eine Einrichtung zur Messung von Verarbeitungsverzögerungen der Verarbeitungseinrichtung beinhaltet und die Einstelleinrichtung angepaßt ist, um ebenso die Phase als Funktion einer Verarbeitungsverzögerung der Verarbeitungseinrichtung einzustellen.

4. Steuereinrichtung zur Löschung sich wiederholender Erscheinungen nach Anspruch 1, bei welcher die Phaseneinrichtung folgendes beinhaltet:
eine Testsignaleinrichtung (60), um ein Testsignal zu erzeugen, wobei das Testsignal zu der Ausgangseinrichtung geliefert wird;
eine dritte Filtereinrichtung (62), um das Testsignal zu empfangen und um ein gefiltertes Signal als Funktion dritter Filtergewichtungen zu liefern;
eine Differenzeinrichtung (70), um ein Differenzsignal des gefilterten Signals und des Erscheinungssignals zu liefern;
eine Verzögerungseinrichtung (64), um ein verzögertes Testsignal von dem Testsignal zu liefern; und
eine dritte Adaptereinrichtung (68), um die dritte Filtergewichte als eine Funktion des verzögerten Testsignals und des Differenzsignals anzupassen.

5. Steuereinrichtung zur Löschung sich wiederholender Erscheinungen nach irgendeinem der vorhergehenden Ansprüche, bei welcher die Phaseneinrichtung eine Einrichtung beinhaltet,um einen vorbestimmten Phasenwert einzustellen.

6. Steuereinrichtung zur Löschung sich wiederholender Erscheinungen nach irgendeinem der vorhergehenden Ansprüche, bei welcher die Zeitablauf-Eingangs-Einrichtung eine Zeitablaufeinrichtung beinhaltet, um die Wiederholungsrate der Erscheinungen zu fühlen und um die Zeitablaufsignale zu erzeugen.

7. Steuereinrichtung zur Löschung sich wiederholender Erscheinungen nach Anspruch 6, bei welcher die Zeitablaufeinrichtung einen Drehzahlmesser beinhaltet.

8. Steuereinrichtung zur Löschung sich wiederholender Erscheinungen nach Anspruch 6, bei welcher die Zeitablaufeinrichtung einen PLL-Kreis beinhaltet.

9. Steuereinrichtung zur Löschung sich wiederholender Erscheinungen nach Anspruch 6, bei welcher die Zeitablauf-Eingangs-Einrichtung einen Funktionsgenerator zur Erzeugung der Zeitablaufsignale beinhaltet.

## Revendications

1. Dispositif de commande d'annulation pour phénomènes répétitifs, comprenant :
des moyens d'entrée de phénomène (18, 28, 30) pour fournir un signal de phénomène représentant un phénomène résiduel à annuler ;
des moyens d'entrée de base de temps (14, 26) pour fournir un signal de base de temps représentatif d'une cadence de répétition du dit phénomène ;
des moyens de traitement (24), comportant des entrées pour le dit signal de phénomène et le dit signal de base de temps, pour engendrer un signal d'annulation afin d'éliminer sensiblement le dit phénomène ;
des moyens de sortie (22, 34, 36) connectés aux dits moyens de traitement pour engendrer un phénomène d'annulation en fonction du dit signal d'annulation ; et
des moyens de filtrage adaptatif, prévus dans les dits moyens de traitement, pour engendrer le dit signal d'annulation par adaptation des caractéristiques de filtrage des moyens de filtrage en fonction du dit signal de phénomène et du dit signal de base de temps ;
caractérisé en ce que les dits moyens de filtrage adaptatif comprennent, pour chaque fréquence à annuler :
des éléments de sinus et de cosinus (40, 42) pour engendrer un sinus et un cosinus du dit signal de base de temps, respectivement ;
un premier et un deuxième éléments de filtrage (44, 46) pour recevoir respectivement les dits signaux de sinus et de cosinus et fournir un premier et un deuxième signaux d'annulation en fonction d'un premier et d'un deuxième poids de filtre des dits premier et deuxième éléments de filtrage respectivement ;
un élément d'addition (48) pour fournir le dit signal d'annulation sous la forme d'une somme des dits premier et deuxième signaux d'annulation ; et
un premier et un deuxième éléments d'adaptation (50, 52) pour adapter les dits premier et deuxième poids de filtre en fonction des dits signaux de sinus et de cosinus respectivement et du dit signal de phénomène ; et caractérisé en outre par :
des moyens de réglage de phase (54, 56), prévus dans les dits moyens de traitement, pour ajuster la phase des dits signaux de sinus et de cosinus fournis aux dits premier et deuxième éléments d'adaptation, de sorte que les dits premier et deuxième éléments d'adaptation se trouvent à l'intérieur d'une phase de 90 degrés du dit signal de phénomène, la dite adaptation de la dite caractéristique de filtrage étant ainsi maintenue à l'intérieur d'une phase de 90 degrés du dit signal de phénomène.

2. Dispositif de commande d'annulation pour phénomènes répétitifs suivant la revendication 1, dans lequel les dits moyens de réglage de phase comprennent des moyens de mesure d'un retard entre la fourniture du dit signal d'annulation et la réception du dit signal de phénomène, et des moyens de réglage pour ajuster la dite phase en fonction d'un retard mesuré.

3. Dispositif de commande d'annulation pour phénomènes répétitifs suivant la revendication 2, dans lequel les dits moyens de réglage de phase comprennent des moyens pour mesurer des retards de traitement des dits moyens de traitement, et les dits moyens de réglage sont prévus également pour ajuster la dite phase en fonction du retard de traitement des dits moyens de traitement.

4. Dispositif de commande d'annulation pour phénomènes répétitifs suivant la revendication 1, dans lequel les dits moyens de réglage de phase comprennent :
un élément de signal de test (60) pour engendrer un signal de test, le dit signal de test étant fourni aux dits moyens de sortie ;
un troisième élément de filtrage (62) pour recevoir le dit signal de test et fournir un signal filtré en fonction des poids du troisième élément de filtrage ;
un élément de différence (70) pour fournir un signal de différence du dit signal filtré et du dit signal de phénomène ;
un élément de retard (64) pour fournir un signal de test retardé à partir du dit signal de test ; et
un troisième élément d'adaptation (68) pour adapter les poids du dit troisième élément de filtrage en fonction du dit signal de test retardé et du dit signal de différence.

5. Dispositif de commande d'annulation pour phénomènes répétitifs suivant une quelconque des revendications précédentes, dans lequel les dits moyens de réglage de phase comprennent des moyens d'établissement d'une valeur de phase prédéterminée.

6. Dispositif de commande d'annulation pour phénomènes répétitifs suivant une quelconque des revendications précédentes, dans lequel les dits moyens d'entrée de base de temps comprennent des moyens de détermination de base de temps pour détecter la dite cadence de répétition du dit phénomène et engendrer les dits signaux de base de temps.

7. Dispositif de commande d'annulation pour phénomènes répétitifs suivant la revendication 6, dans lequel les moyens de détermination de base de temps comprennent un tachymètre.

8. Dispositif de commande d'annulation pour phénomènes répétitifs suivant la revendication 6, dans lequel les dits moyens de détermination de base de temps comprennent un circuit de boucle à blocage de phase.

9. Dispositif de commande d'annulation pour phénomènes répétitifs suivant la revendication 6, dans lequel les dits moyens d'entrée de base de temps comprennent un générateur de fonction pour engendrer les dits signaux de base de temps.
